(19) Europäisches Patentamt
European Patent Office
Office européen des brevets

(11) **EP 4 542 433 A1**

(12) **EUROPEAN PATENT APPLICATION**

(43) Date of publication:
23.04.2025 Bulletin 2025/17

(21) Application number: 24203499.9

(22) Date of filing: 30.09.2024

(51) International Patent Classification (IPC):
*G06F 30/20* (2020.01)

(52) Cooperative Patent Classification (CPC):
G06F 30/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 20.10.2023 JP 2023181374

(71) Applicant: **FUJITSU LIMITED**
**Kawasaki-shi, Kanagawa 211-8588 (JP)**

(72) Inventors:
• **Chen, Bin**
**Kawasaki-shi, Kanagawa, 211-8588 (JP)**
• **SEGAWA, Eigo**
**Kawasaki-shi, Kanagawa, 211-8588 (JP)**

(74) Representative: **Hoffmann Eitle**
**Patent- und Rechtsanwälte PartmbB**
**Arabellastraße 30**
**81925 München (DE)**

(54) **INFORMATION PROCESSING PROGRAM, INFORMATION PROCESSING METHOD, AND MANAGEMENT DEVICE**

(57) An information processing program for causing a management device of a digital twin that reproduces a real world in a virtual space to execute a process includes observing a first movement amount of an object that exists in the real world, specifying a second movement amount of an agent that corresponds to the object in the virtual space, and executing data assimilation processing of the digital twin based on the first movement amount that has been observed and the second movement amount that has been specified.

FIG. 7

EP 4 542 433 A1

**Description**

FIELD

The embodiment discussed herein is related to an information processing program, an information processing method, and a management device.

BACKGROUND

As a technique for representing, in a virtual space, an object existing in a physical space in the real world, there is a technique called digital twin. For example, in the digital twin, the number of passing vehicles or the like on an actual road is collected in real time by using the internet of things (IoT) or the like and traffic simulation is executed, and traffic demand (origin-destination demand (OD)) estimation of people or the like is performed.

Meanwhile, in such digital twin, for example, an error occurs to some extent between a simulation result and the real world. For this reason, for example, there is a technique called data assimilation in which a simulation result is compared with actual observation data, a trajectory of the simulation is corrected based on the observation data, and a result closer to reality is obtained.

Citation List

Patent Literature

Japanese Laid-open Patent Publication No. 2005-182383
Japanese Laid-open Patent Publication No. 2018-101205
Japanese Laid-open Patent Publication No. 2013-206406
U.S. Patent Application Publication No. 2022/245462.

SUMMARY OF INVENTION

TECHNICAL PROBLEMS

However, for example, since data assimilation is not capable of observing every single piece of data in the real world, there is a limit to observation data that may be actually observed and used, and it may not be said that the accuracy of data assimilation is sufficiently high.

In one aspect, an object is to improve the accuracy of data assimilation in a digital twin.

SOLUTION TO PROBREM

According to an aspect of the embodiments, an information processing program for causing a management device of a digital twin that reproduces a real world in a virtual space to execute a process includes observing a first movement amount of an object that exists in the real world, specifying a second movement amount of an agent that corresponds to the object in the virtual space, and executing data assimilation processing of the digital twin based on the first movement amount that has been observed and the second movement amount that has been specified.

EFFECTS OF INVENTION

In one aspect, the accuracy of data assimilation in a digital twin may be improved.

BRIEF DESCRIPTION OF DRAWINGS

FIG. 1 is a diagram illustrating an example of a road network;
FIG. 2 is a diagram illustrating an example of observed link flow data;
FIG. 3 is a diagram illustrating an example of initial OD flow data;
FIG. 4 is a diagram illustrating an example of link flow data obtained by simulation;

FIG. 5 is a diagram illustrating an example of OD flow data update;
FIG. 6 is a flowchart illustrating an example of a flow of OD flow estimation processing;
FIG. 7 is a diagram for describing an intersection branch flow according to the present embodiment;
FIG. 8 is a diagram illustrating a configuration example of an information processing system according to the present embodiment;
FIG. 9 is a diagram illustrating a configuration example of a digital twin management device according to the present embodiment;
FIG. 10 is a diagram for describing an intersection branch ratio according to the present embodiment;
FIG. 11 is a diagram illustrating an example of a differential equation of a link flow evaluation function for q;
FIG. 12 is a diagram illustrating an example of a differential equation of an inflow link flow evaluation function for q;
FIG. 13 is a diagram illustrating an example of initial setting values for OD flow estimation according to the present embodiment;
FIG. 14 is a diagram illustrating a calculation example of each observed value according to the present embodiment;
FIG. 15 is a diagram illustrating an update example of an OD flow according to the present embodiment;
FIG. 16 is a diagram illustrating an example of the effects of the present embodiment (1);
FIG. 17 is a diagram illustrating an example of the effects of the present embodiment (2);
FIG. 18 is a diagram illustrating an example of estimation error evaluation of an OD flow according to the present embodiment; and
FIG. 19 is a diagram for describing a hardware configuration example of the digital twin management device.

DESCRIPTION OF EMBODIMENTS

Hereinafter, an exemplary embodiment of an information processing program, an information processing method, and a management device according to the present embodiment will be described in detail based on the drawings. The present embodiment is not limited by this exemplary embodiment. The exemplary embodiments may be combined as appropriate within the scope without contradiction.

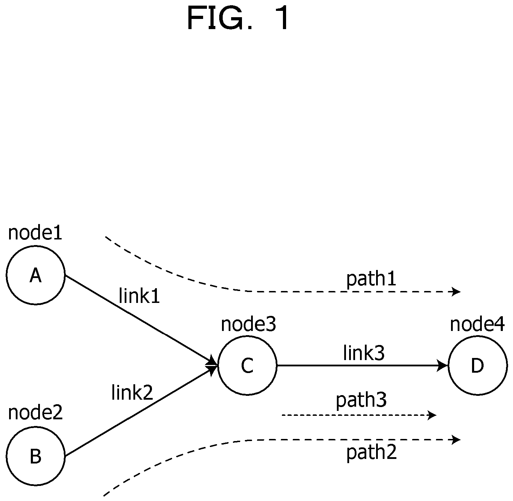

First, a traffic demand estimation (OD estimation) technique performed in a digital twin will be described. FIG. 1 is a diagram illustrating an example of a road network. The example of FIG. 1 illustrates roads as a network (hereinafter referred to as a "road network") with intersections as nodes and roads between intersections as links.

In a road network, as illustrated in FIG. 1, a route from an origin to a destination is indicated as a path. For example, in FIG. 1, A→C→D for moving from A to D is path 1. Although not illustrated, for example, A→X→D in a case of passing through the X point for moving from A to D is indicated as another path.

In the OD estimation technique, for example, a link flow (data), which is the number of vehicles that have passed through a certain link, is measured by a sensor that is installed on each road for measuring vehicles. In the example of FIG. 1, for example, a link flow is the number of vehicles that have passed through link 1 (A→C). In the OD estimation technique, for example, a path flow (data) and an OD flow (data) estimated based on a link flow are estimated. For example, a path flow is the number of vehicles that have passed through a certain path such as path 1. For example, an OD flow is the number of vehicles that have moved from an origin to a destination, such as A to D. In the example of FIG. 1, "OD flow from A to D" = "path flow of path 1" since there is only one path (path 1) as the path from A to D. However, in a case where there is a plurality of paths, the sum of the path flows is the OD flow.

For example, the OD estimation technique is a technique for estimating an OD flow from observable link flows. For example, when the path flow from A to D is path 1 = 10 (vehicles) during the time of 10:00 to 10:15, OD flow = 10 (vehicles) since the OD flow is the sum of the path flows from A to D. However, normally, a path flow and an OD flow may not be directly known. For this reason, for example, a path flow and further an OD flow are estimated from observable link flows by using various techniques. For example, it is assumed that the link flow A→C (link 1) is 25 and the link flow C→D (link 3) is 15 when the number of passing vehicles on each road is observed and counted during the time of 10:00 to 10:15. As described, for example, not all of the 35 vehicles that have passed through link 1 move in the D direction, and not all of the 15 vehicles in link 3 come from the A direction. Not all link flows may be observed. For example, under such various conditions, OD estimation is a problem in which a link flow is measured in advance by an observation camera or the like installed on a road, and an OD flow is estimated based on a known link flow.

In the OD estimation technique, for example, an OD flow is estimated such that an evaluation function represented by the following formula (1) is minimized.

$$\min_{\{q_i\}_i} \quad w_1 \left( \overbrace{\left\| y' - \sum_{i \in D} L_i x_i \right\|_2^2}^{\mathcal{L}_1} \right) + w_2 \left( \overbrace{\left\| z' - \sum_{i \in D} M_i t_i \right\|_2^2}^{\mathcal{L}_2} \right)$$

$$s.t. \quad \{t_i, c_i, \rho_i\}_i = \Lambda(\{f_i\}_i)$$

$$\cdots (1)$$

$$f_i = p_i q_i \quad \forall i \in D$$

$$x_i = \rho_i f_i \quad \forall i \in D$$

$$p_i = \Psi_i(\{c_i\}_i, \{t_i\}_i) \quad \forall i \in D$$

$$q_i \geq 0 \quad \forall i \in D$$

In formula (1), for example, i indicates a mode of transport (for example, common cars: i = 0, trucks: i = 1). For example, $q_i$ indicates an OD flow. For example, $w_i$ indicates a weight for a loss of a link flow. For example, y' indicates observation data of a link flow. For example, D indicates a set of modes of transport = {1, 2}. For example, $L_i$ indicates a totaling matrix for totaling link flows obtained by simulation for comparison with the observation data. For example, $x_i$ indicates a link flow obtained by simulation. For example, $w_2$ indicates a weight for a loss of moving time. For example, z' indicates observation data of moving time of passing through a link. For example, $M_i$ indicates a totaling matrix for totaling the time taken for passing through a link obtained by simulation for comparison with the observation data. For example, $t_i$ indicates time taken for passing through a link. For example, $c_i$ indicates time taken for passing through a path from origin O to destination D. For example, $\rho_i$ indicates a dynamic traffic distribution ratio. For example, $f_i$ indicates a path flow from origin O to destination D. For example, $p_i$ indicates a path selection probability from origin O to destination D. For example, $\Psi_i$ indicates a dynamic user equilibrium matrix. For example, L (cursive) indicates a loss, $L_1$ (cursive) of the first term portion in formula (1) indicates a loss of a link flow, and $L_2$ (cursive) of the second term portion indicates a loss of moving time.

For example, the evaluation function represented by formula (1) is composed of a weighted sum of an error of a cumulative traffic volume observed and estimated in each link within a certain period of time and an error between an observed value and an estimated value of time taken for passing through a link. For example, after an OD is set, each traffic volume is calculated by traffic simulation of an existing technique, a gradient is calculated from an error between the traffic volume and an actual observed value, and the OD is updated.

FIG. 1 illustrates a road network as an example, and as the description of the OD estimation technique, for example, a technique of estimating an OD flow, which is the number of vehicles that have moved from an origin to a destination on the road network, has been described. Although estimation of the number of vehicles moving on a road will be further described below as the description of the OD estimation technique, the OD estimation technique is not limited to the estimation of the number of vehicles moving on a road, and may be, for example, estimation of the number of persons moving on a passage.

The OD estimation technique will be described in more detail. For example, in the example of a road network illustrated in FIG. 1, the number of vehicles (OD flow) departing from node 1 and traveling to node 4 is estimated every 30 minutes during the time of 6:00 to 7:00. In this case, for example, in order to estimate an OD flow for every 30 minutes, the time of 6:00 to 7:00 is divided into two time frames, and OD flows for 6:00 to 6:30 and 6:30 to 7:00 are estimated.

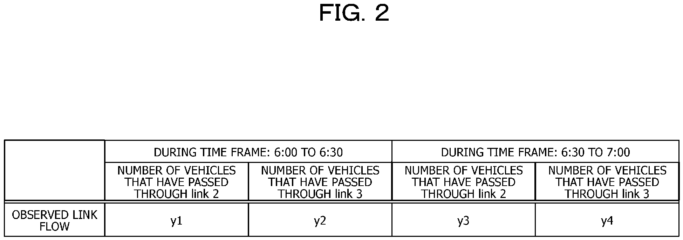

As advance preparation, for example, a road network, a combination of ODs, and a data table such as an OD route selection probability table are prepared. For example, actually observed link flow data such as that illustrated in FIG. 2 is prepared. FIG. 2 is a diagram illustrating an example of observed link flow data. As illustrated in FIG. 2, for example, observed link flow data is y, and pieces of observed link flow data are respectively denoted by y1 to y4 for each time frame and each link flow.

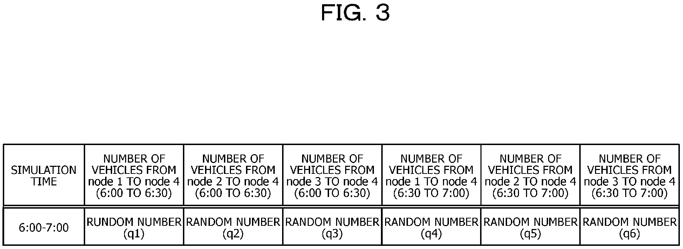

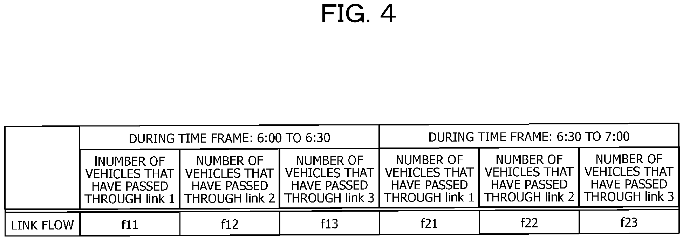

As forward processing, for example, traffic simulation is performed with given OD flows such as those illustrated in FIG. 3, and link flows are totaled. FIG. 3 is a diagram illustrating an example of initial OD flow data. As illustrated in FIG. 3, for example, random numbers q1 to q6 (or may be a certain fixed value) are given as initial ODs. For example, traffic simulation is performed using such ODs as those illustrated in FIG. 3, the number of vehicles that have passed through each link (link flow) is counted on a simulator, and after the simulation, traffic volumes such as those illustrated in FIG. 4 are totaled (the totaled traffic volume is $\rho$). FIG. 4 is a diagram illustrating an example of link flow data obtained by simulation.

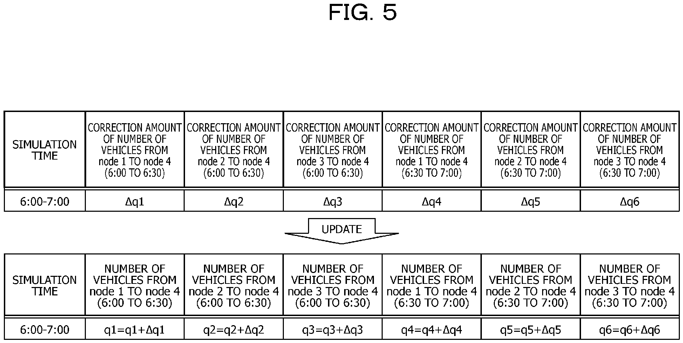

As backward processing, for example, the OD flows are updated based on an error of the link flows. For example,

an error $\Delta y$ between the link flow obtained by simulation and the observed link flow is calculated by the formula "$\Delta y = y - L\rho pq$" (L is an observation matrix, and p is a route selection probability). For example, when the error $\Delta y$ is smaller than a predetermined threshold, the OD estimation ends. A correction amount of OD is calculated by the formula "$\Delta q = wp^T\rho^TL^T\Delta y$" (w is a weight, and is usually a decimal number between 0 and 1). As illustrated in FIG. 5, for example, OD flows q1 to q6 are updated by the formula "$q = q + \Delta q$". FIG. 5 is a diagram illustrating an example of OD flow data update. As iterative processing, traffic simulation is performed by using the updated OD flows, link flows such as those illustrated in FIG. 4 are totaled, and for example, the processing is repeated until the error $\Delta y$ becomes smaller than the predetermined threshold.

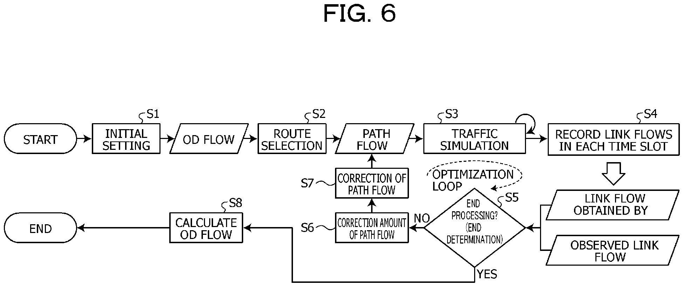

A flow of OD flow estimation processing is summarized in FIG. 6. FIG. 6 is a flowchart illustrating an example of a flow of OD flow estimation processing. For example, in the OD flow estimation processing illustrated in FIG. 6, a link flow is measured every 15 minutes during the time of 6:00 to 11:00, and an OD flow for every 15 minutes during the time of 6:00 to 11:00 is estimated by using the link flow for every 15 minutes.

First, as illustrated in FIG. 6, for example, the digital twin management device 10 initially sets OD flows (step S1). For example, the initial setting of OD flows is setting of random numbers such as that illustrated in FIG. 3. Next, for example, the digital twin management device 10 selects a route for an OD flow of estimation target (step S2). Next, for example, the digital twin management device 10 executes traffic simulation using the path flow calculated using the link flow of the selected route (step S3). For example, in a case where there is a plurality of path flows for the OD flow of estimation target, the processing of steps S3 to S7 may be executed for each path flow.

Next, for example, the digital twin management device 10 totals and records the link flows in each time slot such as those illustrated in FIG. 4 (step S4). For example, the digital twin management device 10 calculates an error between the link flow obtained by simulation and the observed link flow by using an evaluation function, and determines whether the error is smaller than a predetermined threshold and the OD flow estimation processing is to be ended (step S5).

For example, when the error is equal to or larger than the predetermined threshold (step S5: No), as illustrated in FIG. 5, the digital twin management device 10 calculates a correction amount of the path flow based on the error (step S6), and updates and corrects the path flow (step S7). For example, the digital twin management device 10 executes traffic simulation by using the corrected path flow (step S3), and performs optimization while correcting the path flow by repeating the processing until the error becomes smaller than the predetermined threshold (steps S3 to S7).

On the other hand, for example, when the error is smaller than the predetermined threshold (step S5: Yes), the digital twin management device 10 calculates an OD flow based on the link flow obtained by simulation (step S8). As described above, in the case where there is a plurality of path flows, steps S3 to S7 may be executed for each path flow, and when the condition of step S5 is satisfied for all of the plurality of path flows, the processing may proceed to step S8. After the execution of step S8, the OD flow estimation processing illustrated in FIG. 6 ends.

Although the OD flow estimation processing has been described above, for example, an evaluation function used in the processing such as that represented by formula (1) sets an error between a link flow obtained by simulation and an observed link flow as an evaluation target. For this reason, in the evaluation function, for example, depending on the structure of a road network, same link flow may be reproduced even for different OD flows, and there is a possibility that a plurality of local solutions exists that minimizes the evaluation function. For example, this causes a decrease in the estimation accuracy of OD flow and leads to a decrease in the accuracy of data assimilation in digital twin, when the processing is applied to a large-scale road network or in other cases.

Accordingly, in the present embodiment, for example, a branch flow of vehicles to each road estimated by traffic simulation in each observation time slot and at each observation intersection, and a branch flow actually observed in the time slot and at the intersection are used as an estimated value and an observed value of a link flow, respectively. For example, a (intersection) branch flow refers to the number of vehicles that branch off to each road ahead such as turning right or left or traveling straight at each intersection, among vehicles that flow out from a certain road (= link).

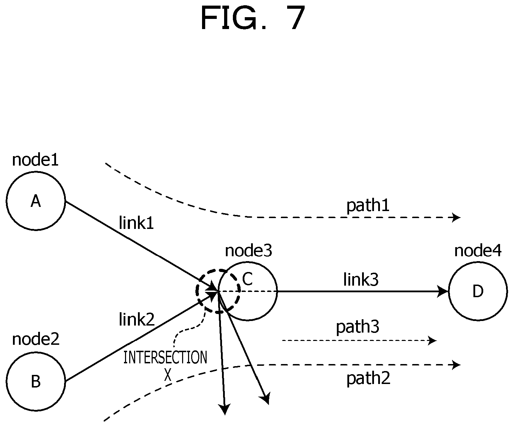

FIG. 7 is a diagram for describing an intersection branch flow according to the present embodiment. As illustrated in FIG. 7, for example, vehicles flowing out from link 1 branch off at intersection X to roads for traveling to B, C, or another destination. In this way, in the present embodiment, for example, a link flow, which is the number of vehicles that flow out from a certain link, is further considered as a sum of branch flows, which are the number of vehicles for each branched-off road, and an OD flow is estimated using the branch flows.

[Configuration of Information Processing System 1]

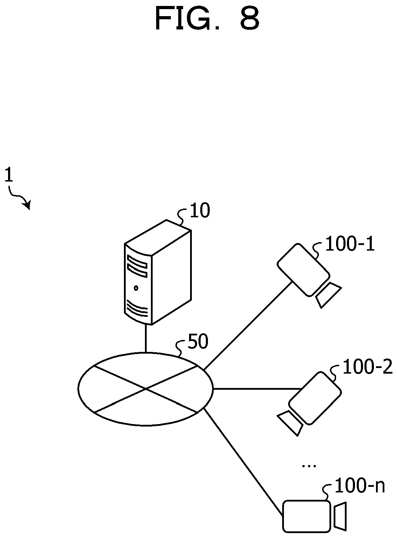

Next, an information processing system 1 for implementing the present embodiment will be described. FIG. 8 is a diagram illustrating a configuration example of the information processing system 1 according to the present embodiment. As illustrated in FIG. 8, in the information processing system 1, for example, the digital twin management device 10 and camera devices 100-1 to 100-n (n is an arbitrary natural number, hereinafter collectively referred to as a "camera device 100") are coupled to each other via a network 50 so as to communicate with each other.

As the network 50, for example, various communication networks such as the Internet may be adopted regardless of wired or wireless. For example, the network 50 may be configured by the Internet and an intranet via a network device such as a gateway or another device (not illustrated) instead of a single network.

For example, the digital twin management device 10 is an information processing device such as a desktop personal computer (PC), a notebook PC, or a server computer that reproduces the real world in a virtual space.

For example, the digital twin management device 10 receives, from the camera device 100, a video captured by the camera device 100 in order to collect information of the real world in real time. Strictly, the video captured by the camera device 100 is a plurality of captured images captured by the camera device 100, for example, a series of frames of a moving image.

For example, the digital twin management device 10 detects an object such as a vehicle or a person from a video by using an existing object detection technique. For example, in the detection of an object such as a vehicle from a video, a predetermined region in the video such as a bounding box, which is a rectangular region surrounding the object such as a vehicle, may be detected for each object. For example, the digital twin management device 10 may detect, from a video, a road, a passage, an intersection, and the like in addition to a vehicle, a person, and the like.

The digital twin management device 10 constructs a digital twin that reproduces the real world in a virtual space. The digital twin management device 10 observes a first movement amount of an object existing in the real world. The digital twin management device 10 specifies a second movement amount of an agent corresponding to the object in the virtual space of the digital twin. For example, the digital twin management device 10 specifies a road or a passage in a virtual space in which a road or a passage in the real world is reproduced, and specifies a second movement amount of an agent corresponding to an object moving on the specified road or passage in the virtual space.

Next, the digital twin management device 10 executes data assimilation processing of the digital twin based on the observed first movement amount and the second movement amount of the agent corresponding to the object in the virtual space. For example, the digital twin management device 10 executes data assimilation processing of the digital twin based on an error between a first movement amount of each vehicle or the like in the real world and a second movement amount of each agent obtained by simulation, such that the first movement amount and the second movement amount coincide with each other.

For example, the digital twin management device 10 arranges the agents corresponding to each vehicle or each person detected from a captured image in the digital twin, and simulates the movement of each agent by using an existing simulation technique such as traffic simulation. For example, the digital twin management device 10 specifies an error between a first movement amount of each vehicle or the like in the real world and a second movement amount of each agent obtained by simulation, and dynamically changes a movement demand of the agent based on the error. The digital twin management device 10 executes data assimilation processing of the digital twin between the first movement amount and the second movement amount based on the changed movement demand. The digital twin management device 10 causes the first movement amount and the second movement amount to coincide with each other and performs data assimilation based on the changed movement demand.

Although the digital twin management device 10 is illustrated as one computer in FIG. 8, it may be a distributed computing system composed of a plurality of computers. The digital twin management device 10 may be a cloud computer device managed by a service provider that provides a cloud computing service.

For example, the camera device 100 is a monitoring camera installed on a road or a passage. For example, the camera device 100 captures a video of a vehicle, a person, or the like that passes through a road or a passage. The video captured by the camera device 100 is transmitted to the digital twin management device 10.

[Functional Configuration of Digital Twin Management Device 10]

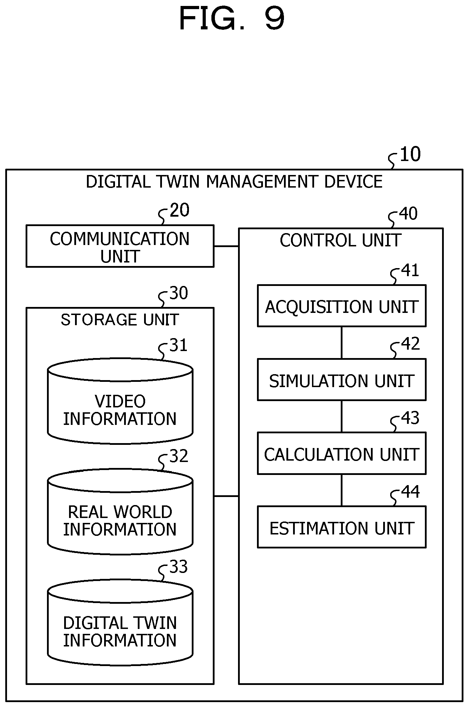

Next, a functional configuration of the digital twin management device 10 will be described. FIG. 9 is a diagram illustrating a configuration example of the digital twin management device 10 according to the present embodiment. As illustrated in FIG. 9, the digital twin management device 10 includes a communication unit 20, a storage unit 30, and a control unit 40.

The communication unit 20 is a processing unit that controls communication with other devices such as the camera device 100, and is, for example, a communication interface such as a network interface card or a Universal Serial Bus (USB) interface.

The storage unit 30 has a function of storing various types of data and programs to be executed by the control unit 40, and is realized by, for example, a storage device such as a memory or a hard disk. For example, the storage unit 30 stores video information 31, real world information 32, digital twin information 33, and the like.

For example, the video information 31 stores a video captured by the camera device 100. A video stored in the video information 31 is a video captured by the camera device 100 and transmitted to the digital twin management device 10. For example, an identifier for uniquely identifying the camera device 100 that has captured the video, imaging date and time, and the like may be stored together in the video information 31.

For example, the real world information 32 stores information of the real world obtained from a video or the like captured by the camera device 100. For example, the information of the real world is information such as the number of vehicles or persons that have passed through each road or passage (= link), and the number or ratio of vehicles or persons that have branched off to each road at an intersection.

For example, the digital twin information 33 stores information related to a digital twin such as an agent corresponding to a vehicle or a person in the real world, an area in the digital twin corresponding to a road, a passage, an intersection, or the like in the real world, and the like. For example, the digital twin information 33 may store information such as the number of agents that have passed through each road or passage (= link), and the number or ratio of agents that have branched off to each road at an intersection, which are derived by simulation in a digital twin.

The above information stored in the storage unit 30 is merely an example, and the storage unit 30 may store various types of information other than the above information.

The control unit 40 is a processing unit that controls the entire digital twin management device 10, and is, for example, a processor or the like. The control unit 40 includes an acquisition unit 41, a simulation unit 42, a calculation unit 43, and an estimation unit 44. Each processing unit is an example of an electronic circuit included in the processor, or an example of a process executed by the processor.

For example, the acquisition unit 41 acquires a video obtained by capturing a vehicle, a person, or the like that passes through a road or a passage. For example, since the video is captured by the camera device 100, transmitted from the camera device 100 at any time, and stored in the video information 31, the acquisition unit 41 acquires the video from the video information 31. For example, the acquisition unit 41 acquires, from the video captured by the camera device 100, information of the real world included in the video by analyzing the acquired video using an existing technique. For example, the information of the real world is information such as the number of vehicles or persons that have passed through each road or passage (= link) (= link flow), and the number or ratio of vehicles or persons that have branched off to each road at an intersection (= branch flow). For example, the acquisition unit 41 observes and acquires a first movement amount of an object such as a vehicle or a person existing in the real world. For this reason, the processing of observing a first movement amount includes processing of detecting an object by using an image captured by the camera device 100 and specifying the first movement amount of the detected object. For example, the processing of observing and acquiring a first movement amount includes processing of observing and acquiring, as the first movement amount, a first number of objects that have moved on a road or a passage between predetermined intersections in the roads or passages in the real world.

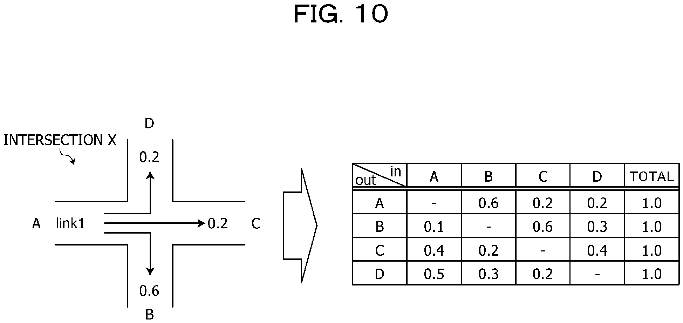

A ratio of vehicles branching off to each road at an intersection (branch ratio) will be described more specifically. FIG. 10 is a diagram for describing an intersection branch ratio according to the present embodiment. As illustrated on the left side in FIG. 10, for example, a vehicle that has flowed out from link 1 and entered from branch A at intersection X exits from any of the branches B to D. For example, the acquisition unit 41 acquires the branch ratio of vehicles that have entered from branch A to branches B to D (0.6, 0.2, and 0.2, respectively) by analyzing a video captured by the camera device 100 installed at intersection X. For example, as illustrated on the right side in FIG. 10, the acquisition unit 41 records a branch ratio to each branch, with each branch at intersection X set as an entrance, in a turn rate table as observation data. For example, in FIG. 10, the number of vehicles that have flowed out from link 1 and entered from branch A at intersection X is the link flow of link 1, and the link flow is the total value of the numbers of vehicles that have branched off to branches B to D (= branch flows). For example, the above-described processing of observing a first movement amount executed by the acquisition unit 41 includes processing of observing and acquiring, as the first movement amount, a first ratio of an object such as a vehicle or a person that has moved to each branch at a predetermined intersection in a road or a passage in the real world.

As the branch ratio data at each intersection, for example, a movement trajectory of a probe car may be acquired from a provider who provides probe car data, and a turn rate table at each intersection may be directly calculated after the movement trajectory is associated with a global positioning system (GPS) position and a road. Alternatively, as the branch ratio data at each intersection, for example, a turn rate table may be acquired from a provider who provides an application programming interface (API) for analyzing a traffic flow at an intersection. Alternatively, as the branch ratio data at each intersection, for example, data of the number of vehicles that make right and left turns and go straight at each intersection at each time slot may be purchased and acquired from a provider.

For example, the simulation unit 42 uses the observed first movement amount and simulates and calculates, in a digital twin, a second movement amount of an agent corresponding to an object such as a vehicle or a person in the real world by using an existing simulation technique such as traffic simulation. For example, the processing of executing simulation may include processing of arranging, for each vehicle or person in the real world, an agent corresponding to the vehicle or person in a virtual space in the digital twin.

For example, the calculation unit 43 specifies an error between the first movement amount observed and acquired by the acquisition unit 41 and the second movement amount of the agent corresponding to an object such as a vehicle or a person in the virtual space. The processing of specifying an error includes processing of calculating, as the error, a first error between a first number of objects that have moved on a road or a passage between predetermined intersections in the real world and a second number of agents that have moved on a road or a passage between predetermined intersections in the roads or passages in the virtual space. The processing of specifying an error includes processing of calculating, as the error, a second error between a first ratio of an object that has moved to each branch at a predetermined intersection in the real world and a second ratio of an agent that has moved to each branch at a predetermined intersection in the roads or passages in the virtual space. For example, in the present embodiment, a branch flow is taken into consideration, and in the OD flow estimation processing in the present embodiment, an OD flow is estimated such that the following formula (2), which is obtained by modifying the evaluation function represented by formula (1) so that a branch flow is taken into consideration, is minimized.

$$\min_{q} w_1 (\|y' - Lx\|_2^2) + w_2 (\|\eta' - K\varphi\|_2^2) \qquad \cdots (2)$$

In formula (2), for example, the first term including $w_1$ is similar to that in formula (1). For example, $w_2$ indicates a weight for a loss of a branch flow. For example, $\eta$ indicates observation data of a link branch flow. For example, K indicates a matrix for totaling link branch flows in a simulation for comparison with the observation data. For example, $\varphi$ indicates a branch flow obtained by simulation. For example, $\tau$ indicates a dynamic distribution ratio of a branch flow.

The following formula (3) is obtained by converting formula (2) with "x = $\rho$pq" (from formula (1)) and "$\varphi$ = $\tau$pq" in formula (2).

$$\min_{q} w_1 (\|y' - L\rho pq\|_2^2) + w_2 (\|\eta' - K\tau pq\|_2^2) \qquad \cdots (3)$$

For evaluation function L (cursive), when the first term portions in formula (2) and (3) are loss $L_1$ (cursive) of a link flow, and the second term portions are loss $L_2$ (cursive) of a branch flow, the following formula (4) is obtained.

$$\mathcal{L} = w_1 \mathcal{L}_1 + w_2 \mathcal{L}_2 \qquad \cdots (4)$$

In formula (4), for example, $L_1$ (cursive) and $L_2$ (cursive) are represented by the following formulae (5) and (6), respectively.

$$\mathcal{L}_1 = \|y' - y\|_2^2 \qquad \cdots (5)$$

In formula (5), for example, y = Lx, x = pf, and f = pq.

$$\mathcal{L}_2 = \|\eta' - \eta\|_2^2 \qquad \cdots (6)$$

In formula (6), for example, $\eta$ = K$\varphi$, $\varphi$ = $\tau$f, and f = pq.
For example, a differential equation of evaluation function L (cursive) for q is represented by the following formula (7).

$$\frac{\partial \mathcal{L}}{\partial q} = \frac{\partial \mathcal{L}}{\partial \mathcal{L}_1}\frac{\partial \mathcal{L}_1}{\partial q} + \frac{\partial \mathcal{L}}{\partial \mathcal{L}_2}\frac{\partial \mathcal{L}_2}{\partial q} \qquad \cdots (7)$$
$$= -2w_1 p^T \rho^T L^T (y' - y) - 2w_2 p^T \tau^T K^T (\eta' - \eta)$$

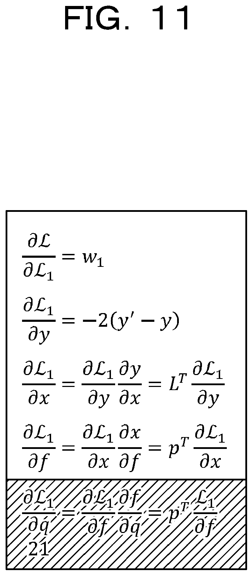

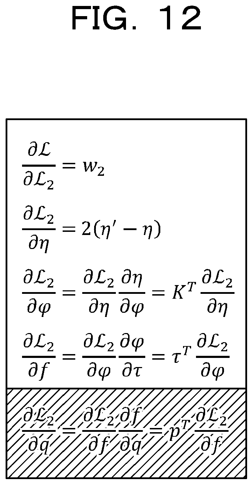

For example, differential equations of evaluation function $L_1$ (cursive) of a link flow and evaluation function $L_2$ (cursive) of a branch flow for q may be calculated as illustrated in FIG. 11 and FIG. 12, respectively. FIG. 11 is a diagram illustrating an example of a differential equation of link flow evaluation function $L_1$ for q. FIG. 12 is a diagram illustrating an example of a differential equation of inflow link flow evaluation function $L_2$ for q.
For example, the calculation unit 43 dynamically changes a movement demand of the agent in the virtual space based on the specified error between the first movement amount and the second movement amount, and executes data assimilation processing between the first movement amount and the second movement amount based on the changed movement demand such that the first movement amount and the second movement amount coincide with each other. For example, an update value of OD flow q "$\Delta q = -2p^T(w_1\rho^T L^T(y'-y) + w_2\tau^T K^T(\eta'-\eta))$" is calculated based on the error between the first movement amount and the second movement amount, and OD flow q is updated as "$q \leftarrow max(0, q - \gamma\Delta q)$".

For example, the estimation unit 44 estimates a movement amount of an object such as a vehicle or a person from a predetermined origin in the real world to a destination such that a weighted sum of the first error and the second error is minimized. For example, the first error is an error between a first number of objects that have moved on a road or a passage between predetermined intersections in the real world and a second number of agents that have moved on a road or a passage between predetermined intersections in the roads or passages in the virtual space, which is calculated by the calculation unit 43. For example, the second error is an error between a first ratio of an object that has moved to each branch at a predetermined intersection in the real world and a second ratio of an agent that has moved to each branch at a predetermined intersection in the roads or passages in the virtual space, which is calculated by the calculation unit 43.

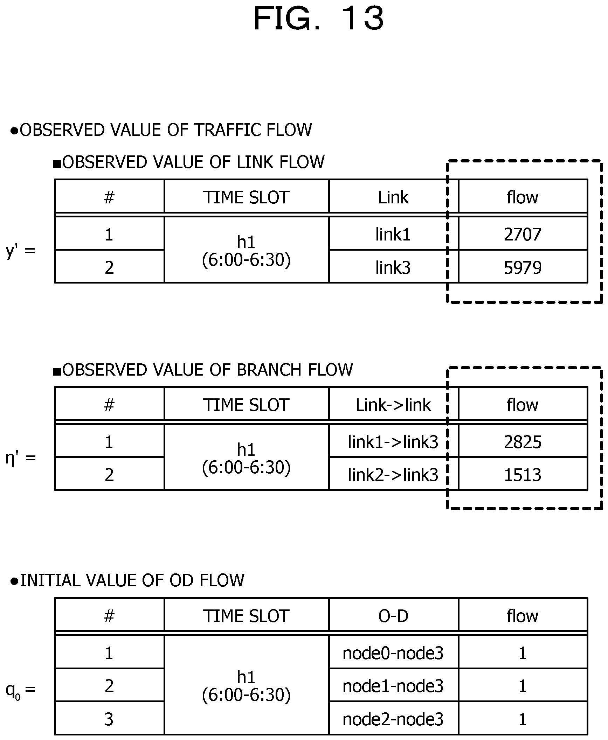

Next, OD flow estimation according to the present embodiment will be described in more detail. FIG. 13 is a diagram illustrating an example of initial setting values for OD flow estimation according to the present embodiment. In the OD flow estimation according to the present embodiment, for example, an OD flow is estimated by using a pseudo observed value of a traffic flow. FIG. 13 is a diagram illustrating an example of initial setting values for OD flow estimation according to the present embodiment. As indicated by broken line portions in FIG. 13, for example, pseudo observed values of link flow and branch flow are set as initial setting values of an observed value of traffic flow. As illustrated in the lower part of FIG. 13, initial value $q_0$ of OD flow is set.

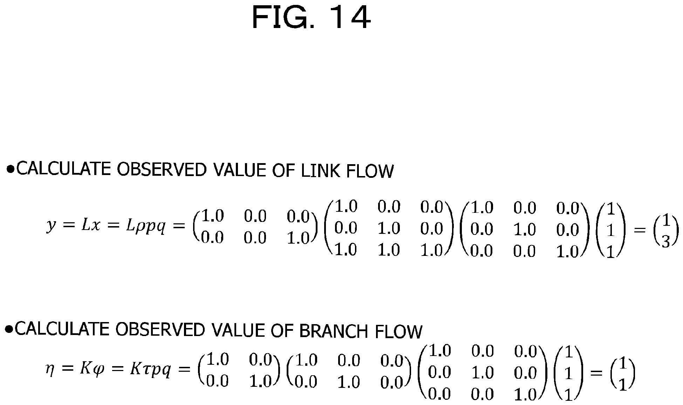

Next, for example, the digital twin management device 10 executes traffic simulation by using each observed value and OD flow that have been initially set as illustrated in FIG. 13, and calculates observed value y of link flow and observed value $\eta$ of branch flow as illustrated in FIG. 14. FIG. 14 is a diagram illustrating a calculation example of each observed value according to the present embodiment.

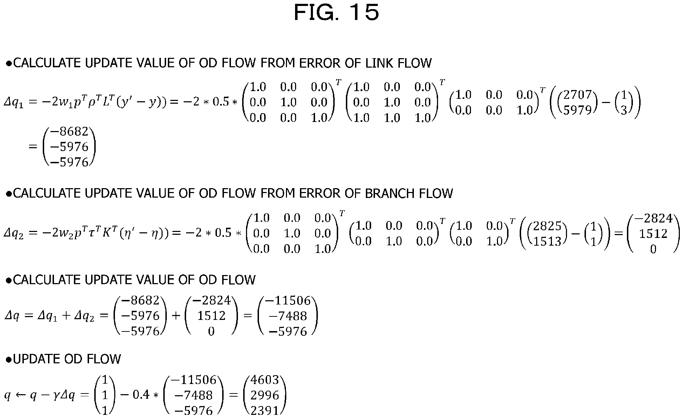

Next, for example, the digital twin management device 10 calculates update values $\Delta q_1$ and $\Delta q_2$ of OD flow from respective errors of link flow and branch flow as illustrated in FIG. 15 by using y and $\eta$ calculated by simulation as illustrated in FIG. 14. For example, as illustrated in FIG. 15, the digital twin management device 10 calculates an update value $\Delta q$ of OD flow by using the calculated update values $\Delta q_1$ and $\Delta q_2$ of OD flow, and updates OD flow q as "$q \leftarrow q - \gamma\Delta q$" by using the update value $\Delta q$. FIG. 15 is a diagram illustrating an update example of an OD flow according to the present embodiment.

For example, the digital twin management device 10 repeats optimization processing as follows. For example, the digital twin management device 10 performs forward processing by using an OD flow updated in backward as a known OD flow, and calculates a link flow and a branch flow. For example, the digital twin management device 10 compares the link flow and the branch flow calculated in forward with actually observed values, and updates the OD flow.

[Effects]

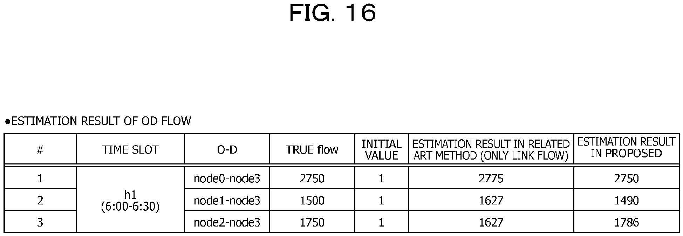

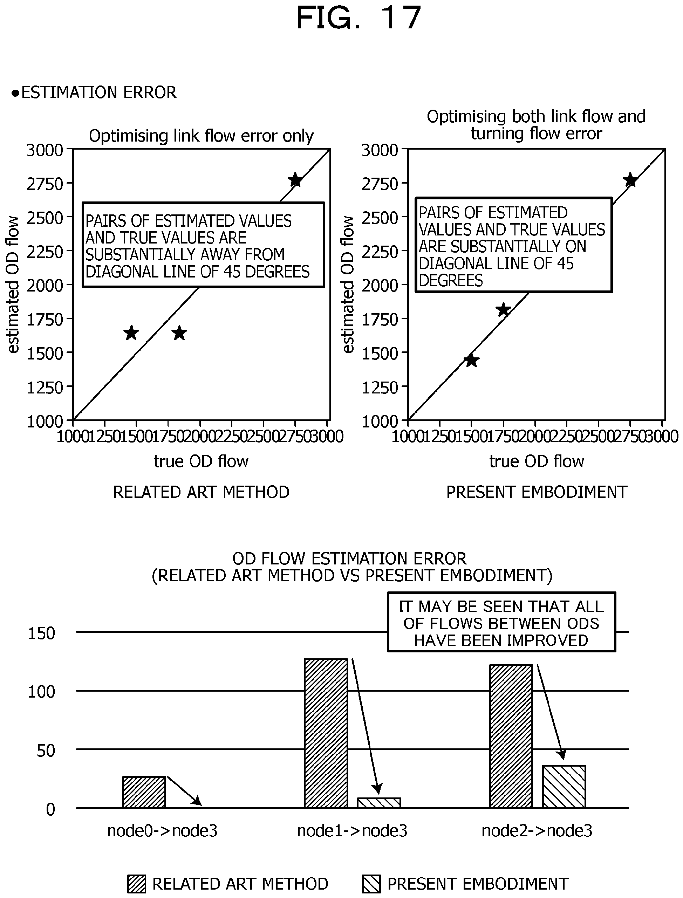

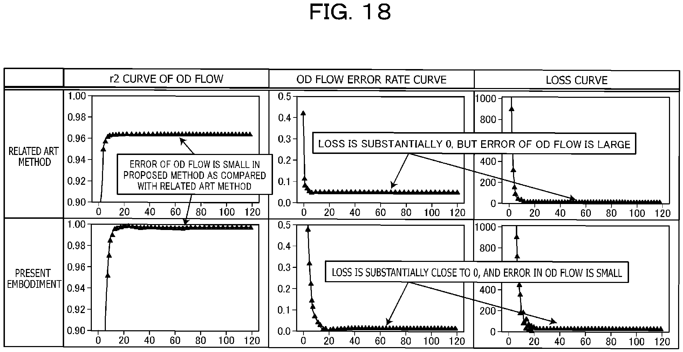

The digital twin management device 10 may reflect a situation in the real world, and may improve the accuracy of data assimilation in a digital twin in a virtual space. FIG. 16 is a diagram illustrating an example of the effects of the present embodiment (1). FIG. 17 is a diagram illustrating an example of the effects of the present embodiment (2). FIG. 18 is a diagram illustrating an example of estimation error evaluation of an OD flow according to the present embodiment. As illustrated in FIG. 16 to FIG. 18, in the OD estimation according to the present embodiment in consideration of a branch flow, an estimation error is further reduced, and data assimilation accuracy and estimation accuracy are improved, as compared with the related art method using an evaluation function such as that illustrated in formula (1).

As described above, the digital twin management device 10 that reproduces the real world in a virtual space observes a first movement amount of an object existing in the real world, specifies a second movement amount of an agent corresponding to the object in the virtual space, and executes data assimilation processing of a digital twin based on the observed first movement amount and the specified second movement amount.

In this way, the digital twin management device 10 performs assimilation of both movement amounts based on an error between a movement amount of an object observed in the real world and a movement amount of an agent obtained by simulation in the digital twin. Accordingly, the digital twin management device 10 may improve the accuracy of data assimilation in the digital twin.

The digital twin management device 10 specifies an error between the observed first movement amount and the second movement amount of the agent corresponding to the object in the virtual space, and dynamically changes a movement demand of the agent in the virtual space based on the specified error, and the processing of executing data assimilation processing executed by the digital twin management device 10 includes processing of executing data assimilation processing of the digital twin between the first movement amount and the second movement amount based on the changed movement demand.

Accordingly, the digital twin management device 10 may improve the accuracy of data assimilation in the digital twin.

The processing of observing a first movement amount executed by the digital twin management device 10 includes processing of observing a first movement amount of an object in a road or a passage in the real world, the processing of specifying an error includes processing of specifying an error between the observed first movement amount and the second movement amount of the agent corresponding to the object in the road or passage in the virtual space, and the processing of executing data assimilation processing includes processing of executing data assimilation processing such that the first movement amount and the second movement amount coincide with each other.

Accordingly, the digital twin management device 10 may improve the accuracy of data assimilation in the digital twin.

The processing of observing a first movement amount executed by the digital twin management device 10 includes processing of detecting an object by using an image captured by a camera and specifying a first movement amount of the detected object, and the digital twin management device 10 simulates and calculates a second movement amount in the digital twin by using the observed first movement amount.

Accordingly, the digital twin management device 10 may improve the accuracy of data assimilation in the digital twin.

The processing of observing a first movement amount executed by the digital twin management device 10 includes processing of observing, as the first movement amount, a first number of objects that have moved on a road or a passage between predetermined intersections in roads or passages in the real world, and the processing of specifying an error includes processing of calculating, as the error, a first error between the first number and a second number of agents that have moved on a road or a passage between predetermined intersections in the roads or passages in the virtual space.

Accordingly, the digital twin management device 10 may improve the accuracy of data assimilation in the digital twin.

The processing of observing a first movement amount executed by the digital twin management device 10 includes processing of observing, as the first movement amount, a first ratio of an object that has moved to each branch at a predetermined intersection in a road or a passage in the real world, and the processing of specifying an error includes processing of calculating, as the error, a second error between the first ratio and a second ratio of an agent that has moved to each branch at a predetermined intersection in the roads or passages in the virtual space.

Accordingly, the digital twin management device 10 may further improve the accuracy of data assimilation in the digital twin.

The digital twin management device 10 estimates a movement amount of an object from a predetermined origin in the real world to a destination such that a weighted sum of the first error and the second error is minimized.

Accordingly, the digital twin management device 10 may improve the accuracy of data assimilation in the digital twin.

The processing of specifying a second movement amount executed by the digital twin management device 10 includes processing of specifying a road or a passage in a virtual space in which a road or a passage in the real world is reproduced, and specifying a second movement amount of an agent corresponding to an object moving on the specified road or passage in the virtual space.

Accordingly, the digital twin management device 10 may improve the accuracy of data assimilation in the digital twin.

The digital twin management device 10 executes processing of predicting, in a period from after the data assimilation processing of the digital twin is completed to before the next data assimilation processing is executed, the presence or absence of abnormality in the movement amount of an object existing in the real world by performing simulation in the virtual space of the digital twin by using an agent in the virtual space, specifying a road or a passage in which an abnormality is predicted when the abnormality is predicted, and causing a display device to display an image in which the specified road or passage is highlighted.

Accordingly, the digital twin management device 10 may improve the accuracy of data assimilation in the digital twin.

[Application Processing]

Application processing of a digital twin after data assimilation processing of the digital twin is completed will be described. The digital twin management device 10 repeatedly executes data assimilation processing of a digital twin and application processing in the digital twin.

First, in a period from after the data assimilation processing of the digital twin is completed to before the next data assimilation processing is executed, the digital twin management device 10 performs simulation in a virtual space by using an agent in the virtual space. For example, after the data assimilation processing of the digital twin is completed, the digital twin management device 10 predicts the presence or absence of abnormality of an object existing in the real world by performing simulation in a virtual space by using an agent in the virtual space. For example, the digital twin management device 10 predicts, based on a second movement amount, the presence or absence of occurrence of an abnormal change in the movement amount of a person or a vehicle according to a traffic condition due to the occurrence of an accident or the like. For example, the digital twin management device 10 predicts the presence or absence of abnormality in the movement amount of an object existing in the real world by inputting a second movement amount to a machine learning model in which the second movement amount and the presence or absence of abnormality are learned.

Next, when abnormality is predicted, the digital twin management device 10 specifies a road or a passage where the abnormality is predicted. For example, when abnormality is predicted, the digital twin management device 10 specifies a road or a passage where an object for which an abnormal movement amount is predicted is located. The digital twin management device 10 causes a display device to display information in which the specified road or passage is highlighted on a map. For example, the digital twin management device 10 causes a display to display a screen in which the specified road is highlighted among the plurality of roads included in the map.

[System]

Unless otherwise specified, the processing procedures, control procedures, specific names, and information including various types of data and parameters described in the above description or drawings may be arbitrarily changed. The specific examples, distribution, numerical values, and the like described in the exemplary embodiment are merely examples, and may be arbitrarily changed.

The specific form of distribution or integration of the constituent elements in each device is not limited to that illustrated in the drawings. For example, all or a part of the constituent elements may be functionally or physically distributed or integrated in arbitrary units depending on various types of loads, usage states, or the like. All or an arbitrary part of each processing function of each device may be realized by a central processing unit (CPU) and a program analyzed and executed by the CPU, or may be realized as hardware using wired logic.

[Hardware]

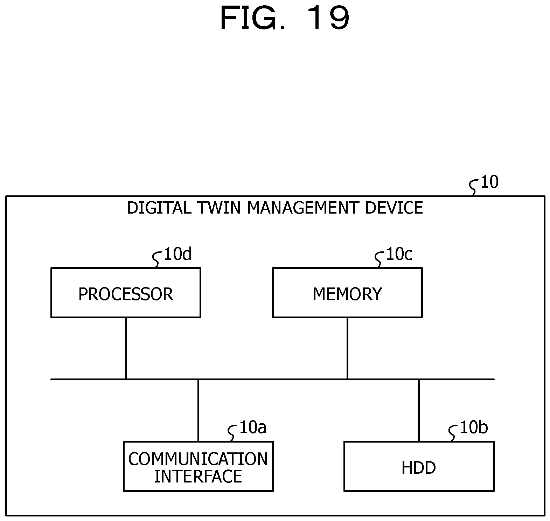

FIG. 19 is a diagram for describing a hardware configuration example of the digital twin management device 10. As illustrated in FIG. 19, the digital twin management device 10 includes a communication interface 10a, a hard disk drive (HDD) 10b, a memory 10c, and a processor 10d. The components illustrated in FIG. 19 are coupled to each other by a bus or the like.

The communication interface 10a is a network interface card or the like and performs communication with other servers. The HDD 10b stores programs and data for causing the functions illustrated in FIG. 9 to operate.

The processor 10d is a hardware circuit that causes a process of executing each function described in FIG. 9 and the like to operate by reading, from the HDD 10b or the like, a program for executing processing similar to that of each processing unit illustrated in FIG. 9 and loading the program to the memory 10c. For example, this process executes a function similar to that of each processing unit included in the digital twin management device 10. For example, the processor 10d reads, from the HDD 10b or the like, a program having functions similar to those of the acquisition unit 41, the simulation unit 42, the calculation unit 43, the estimation unit 44, and the like. The processor 10d executes a process of executing processing similar to that of the acquisition unit 41, the simulation unit 42, the calculation unit 43, the estimation unit 44, and the like.

As described above, the digital twin management device 10 operates as an information processing device that executes operation control processing by reading and executing the program for executing processing similar to that of each processing unit illustrated in FIG. 9. The digital twin management device 10 may also realize a function similar to that of the exemplary embodiment described above by reading a program from a recording medium by a medium reading device and executing the read program. The program referred to in this other exemplary embodiment is not limited to being executed by the digital twin management device 10. For example, the present embodiment may be similarly applied to a case where another information processing device executes the program, or a case where the digital twin management device 10 and another information processing device execute the program in cooperation with each other.

The program for executing processing similar to that of each processing unit illustrated in FIG. 9 may be distributed through a network such as the Internet. This program may be recorded on a computer-readable recording medium such as a hard disk, a flexible disk (FD), a compact disc read-only memory (CD-ROM), a magneto-optical (MO) disk, or a Digital Versatile Disc (DVD), and executed by being read from the recording medium by a computer.

The following appendices are further disclosed in relation to the embodiment including the exemplary embodiment described above.

**Claims**

1. An information processing program for causing a management device of a digital twin that reproduces a real world in a virtual space to execute a process comprising:

    observing a first movement amount of an object that exists in the real world;
    specifying a second movement amount of an agent that corresponds to the object in the virtual space; and
    executing data assimilation processing of the digital twin based on the first movement amount that has been observed and the second movement amount that has been specified.

2. The information processing program according to claim 1, wherein

    an error between the first movement amount that has been observed and a second movement amount of an agent that corresponds to the object in the virtual space is specified,
    a movement demand of the agent in the virtual space is dynamically changed based on the error that has been specified, and
    the executing of data assimilation processing includes a process of executing data assimilation processing of the digital twin between the first movement amount and the second movement amount based on the movement demand that has been changed.

3. The information processing program according to claim 2, wherein

    the observing of a first movement amount includes a process of observing a first movement amount of an object in a road or a passage in the real world,
    the specifying of an error includes a process of specifying an error between the first movement amount that has been observed and a second movement amount of an agent that corresponds to the object in a road or a passage in the virtual space, and
    the executing of data assimilation processing includes a process of executing the data assimilation processing such that the first movement amount and the second movement amount coincide with each other.

4. The information processing program according to claim 2, wherein

    the observing of a first movement amount includes a process of detecting the object by using an image captured by a camera, and specifying a first movement amount of the object that has been detected, and
    a management device of the digital twin is caused to execute a process of simulating and calculating the second movement amount in the digital twin by using the first movement amount that has been observed.

5. The information processing program according to claim 3, wherein

    the observing of a first movement amount includes a process of observing, as the first movement amount, a first number of the object that has moved on a road or a passage between predetermined intersections in roads or passages in the real world, and
    the specifying of an error includes a process of calculating, as the error, a first error between the first number and a second number of the agent that has moved on a road or a passage between predetermined intersections in roads or passages in the virtual space.

6. The information processing program according to claim 5, wherein

    the observing of a first movement amount includes a process of observing, as the first movement amount, a first ratio of the object that has moved to each branch at a predetermined intersection in roads or passages in the real world, and
    the specifying of an error includes a process of calculating, as the error, a second error between the first ratio and a second ratio of the agent that has moved to each branch at a predetermined intersection in roads or passages in the virtual space.

7. The information processing program according to claim 6, wherein
    the management device of the digital twin is configured to:
    estimate a movement amount of the object from a predetermined origin in the real world to a destination such that a weighted sum of the first error and the second error is minimized.

8. The information processing program according to claim 3, wherein
the specifying of a second movement amount includes a process of specifying a road or a passage in a virtual space in which a road or a passage in the real world is reproduced, and specifying a second movement amount of an agent that corresponds to the object that moves on the road or passage in a virtual space that has been specified.

9. The information processing program according to claim 3, wherein
the management device of the digital twin is configured to:

in a period from after data assimilation processing of the digital twin is completed to before next data assimilation processing is executed, predicting a presence or absence of abnormality in a movement amount of an object present in the real world by performing simulation in a virtual space of the digital twin by using an agent in the virtual space;
specifying a road or a passage in which the abnormality is predicted when the abnormality is predicted; and
causing a display device to display an image in which the road or the passage that has been specified is highlighted.

10. An information processing method implemented by a management device of a digital twin that reproduces a real world in a virtual space, the information processing method comprising:

observing a first movement amount of an object that exists in the real world;
specifying a second movement amount of an agent that corresponds to the object in the virtual space; and
executing data assimilation processing of the digital twin based on the first movement amount that has been observed and the second movement amount that has been specified.

11. A management device of a digital twin that reproduces a real world in a virtual space comprising:
a processor configured to:

observe a first movement amount of an object that exists in the real world;
specify a second movement amount of an agent that corresponds to the object in the virtual space; and
execute data assimilation processing of the digital twin based on the first movement amount that has been observed and the second movement amount that has been specified.

# FIG. 1

FIG. 2

| | DURING TIME FRAME: 6:00 TO 6:30 | | DURING TIME FRAME: 6:30 TO 7:00 | |
|---|---|---|---|---|
| | NUMBER OF VEHICLES THAT HAVE PASSED THROUGH link 2 | NUMBER OF VEHICLES THAT HAVE PASSED THROUGH link 3 | NUMBER OF VEHICLES THAT HAVE PASSED THROUGH link 2 | NUMBER OF VEHICLES THAT HAVE PASSED THROUGH link 3 |
| OBSERVED LINK FLOW | y1 | y2 | y3 | y4 |

FIG. 3

| SIMULATION TIME | NUMBER OF VEHICLES FROM node 1 TO node 4 (6:00 TO 6:30) | NUMBER OF VEHICLES FROM node 2 TO node 4 (6:00 TO 6:30) | NUMBER OF VEHICLES FROM node 3 TO node 4 (6:00 TO 6:30) | NUMBER OF VEHICLES FROM node 1 TO node 4 (6:30 TO 7:00) | NUMBER OF VEHICLES FROM node 2 TO node 4 (6:30 TO 7:00) | NUMBER OF VEHICLES FROM node 3 TO node 4 (6:30 TO 7:00) |
|---|---|---|---|---|---|---|
| 6:00-7:00 | RUNDOM NUMBER (q1) | RANDOM NUMBER (q2) | RANDOM NUMBER (q3) | RANDOM NUMBER (q4) | RANDOM NUMBER (q5) | RANDOM NUMBER (q6) |

FIG. 4

| | DURING TIME FRAME: 6:00 TO 6:30 | | | DURING TIME FRAME: 6:30 TO 7:00 | | |
|---|---|---|---|---|---|---|
| | INUMBER OF VEHICLES THAT HAVE PASSED THROUGH link 1 | NUMBER OF VEHICLES THAT HAVE PASSED THROUGH link 2 | NUMBER OF VEHICLES THAT HAVE PASSED THROUGH link 3 | NUMBER OF VEHICLES THAT HAVE PASSED THROUGH link 1 | NUMBER OF VEHICLES THAT HAVE PASSED THROUGH link 2 | NUMBER OF VEHICLES THAT HAVE PASSED THROUGH link 3 |
| LINK FLOW | f11 | f12 | f13 | f21 | f22 | f23 |

FIG. 5

| SIMULATION TIME | CORRECTION AMOUNT OF NUMBER OF VEHICLES FROM node 1 TO node 4 (6:00 TO 6:30) | CORRECTION AMOUNT OF NUMBER OF VEHICLES FROM node 2 TO node 4 (6:00 TO 6:30) | CORRECTION AMOUNT OF NUMBER OF VEHICLES FROM node 3 TO node 4 (6:00 TO 6:30) | CORRECTION AMOUNT OF NUMBER OF VEHICLES FROM node 1 TO node 4 (6:30 TO 7:00) | CORRECTION AMOUNT OF NUMBER OF VEHICLES FROM node 2 TO node 4 (6:30 TO 7:00) | CORRECTION AMOUNT OF NUMBER OF VEHICLES FROM node 3 TO node 4 (6:30 TO 7:00) |
|---|---|---|---|---|---|---|
| 6:00-7:00 | $\Delta q1$ | $\Delta q2$ | $\Delta q3$ | $\Delta q4$ | $\Delta q5$ | $\Delta q6$ |

UPDATE

| SIMULATION TIME | NUMBER OF VEHICLES FROM node 1 TO node 4 (6:00 TO 6:30) | NUMBER OF VEHICLES FROM node 2 TO node 4 (6:00 TO 6:30) | NUMBER OF VEHICLES FROM node 3 TO node 4 (6:00 TO 6:30) | NUMBER OF VEHICLES FROM node 1 TO node 4 (6:30 TO 7:00) | NUMBER OF VEHICLES FROM node 2 TO node 4 (6:30 TO 7:00) | NUMBER OF VEHICLES FROM node 3 TO node 4 (6:30 TO 7:00) |
|---|---|---|---|---|---|---|
| 6:00-7:00 | $q1=q1+\Delta q1$ | $q2=q2+\Delta q2$ | $q3=q3+\Delta q3$ | $q4=q4+\Delta q4$ | $q5=q5+\Delta q5$ | $q6=q6+\Delta q6$ |

# FIG. 6

# FIG. 7

# FIG. 8

# FIG. 9

DIGITAL TWIN MANAGEMENT DEVICE  ⌐10

COMMUNICATION UNIT  ⌐20

CONTROL UNIT  ⌐40

STORAGE UNIT  ⌐30

VIDEO INFORMATION  ⌐31

REAL WORLD INFORMATION  ⌐32

DIGITAL TWIN INFORMATION  ⌐33

ACQUISITION UNIT  ⌐41

SIMULATION UNIT  ⌐42

CALCULATION UNIT  ⌐43

ESTIMATION UNIT  ⌐44

# FIG. 10

| out \ in | A | B | C | D | TOTAL |
|---|---|---|---|---|---|
| A | - | 0.6 | 0.2 | 0.2 | 1.0 |
| B | 0.1 | - | 0.6 | 0.3 | 1.0 |
| C | 0.4 | 0.2 | - | 0.4 | 1.0 |
| D | 0.5 | 0.3 | 0.2 | - | 1.0 |

# FIG. 11

$$\frac{\partial \mathcal{L}}{\partial \mathcal{L}_1} = w_1$$

$$\frac{\partial \mathcal{L}_1}{\partial y} = -2(y' - y)$$

$$\frac{\partial \mathcal{L}_1}{\partial x} = \frac{\partial \mathcal{L}_1}{\partial y}\frac{\partial y}{\partial x} = L^T \frac{\partial \mathcal{L}_1}{\partial y}$$

$$\frac{\partial \mathcal{L}_1}{\partial f} = \frac{\partial \mathcal{L}_1}{\partial x}\frac{\partial x}{\partial f} = p^T \frac{\partial \mathcal{L}_1}{\partial x}$$

$$\frac{\partial \mathcal{L}_1}{\partial q} = \frac{\partial \mathcal{L}_1}{\partial f}\frac{\partial f}{\partial q} = p^T \frac{\partial \mathcal{L}_1}{\partial f}$$

21

# FIG. 12

$$\frac{\partial \mathcal{L}}{\partial \mathcal{L}_2} = w_2$$

$$\frac{\partial \mathcal{L}_2}{\partial \eta} = 2(\eta' - \eta)$$

$$\frac{\partial \mathcal{L}_2}{\partial \varphi} = \frac{\partial \mathcal{L}_2}{\partial \eta}\frac{\partial \eta}{\partial \varphi} = K^T \frac{\partial \mathcal{L}_2}{\partial \eta}$$

$$\frac{\partial \mathcal{L}_2}{\partial f} = \frac{\partial \mathcal{L}_2}{\partial \varphi}\frac{\partial \varphi}{\partial \tau} = \tau^T \frac{\partial \mathcal{L}_2}{\partial \varphi}$$

$$\frac{\partial \mathcal{L}_2}{\partial q} = \frac{\partial \mathcal{L}_2}{\partial f}\frac{\partial f}{\partial q} = p^T \frac{\partial \mathcal{L}_2}{\partial f}$$

# FIG. 13

●OBSERVED VALUE OF TRAFFIC FLOW

■OBSERVED VALUE OF LINK FLOW

$y' =$

| # | TIME SLOT | Link | flow |
|---|---|---|---|
| 1 | h1 (6:00-6:30) | link1 | 2707 |
| 2 | | link3 | 5979 |

■OBSERVED VALUE OF BRANCH FLOW

$\eta' =$

| # | TIME SLOT | Link->link | flow |
|---|---|---|---|
| 1 | h1 (6:00-6:30) | link1->link3 | 2825 |
| 2 | | link2->link3 | 1513 |

●INITIAL VALUE OF OD FLOW

$q_0 =$

| # | TIME SLOT | O-D | flow |
|---|---|---|---|
| 1 | h1 (6:00-6:30) | node0-node3 | 1 |
| 2 | | node1-node3 | 1 |
| 3 | | node2-node3 | 1 |

# FIG. 14

●CALCULATE OBSERVED VALUE OF LINK FLOW

$$y = Lx = L\rho pq = \begin{pmatrix} 1.0 & 0.0 & 0.0 \\ 0.0 & 0.0 & 1.0 \end{pmatrix} \begin{pmatrix} 1.0 & 0.0 & 0.0 \\ 0.0 & 1.0 & 0.0 \\ 1.0 & 1.0 & 1.0 \end{pmatrix} \begin{pmatrix} 1.0 & 0.0 & 0.0 \\ 0.0 & 1.0 & 0.0 \\ 0.0 & 0.0 & 1.0 \end{pmatrix} \begin{pmatrix} 1 \\ 1 \\ 1 \end{pmatrix} = \begin{pmatrix} 1 \\ 3 \end{pmatrix}$$

●CALCULATE OBSERVED VALUE OF BRANCH FLOW

$$\eta = K\varphi = K\tau pq = \begin{pmatrix} 1.0 & 0.0 \\ 0.0 & 1.0 \end{pmatrix} \begin{pmatrix} 1.0 & 0.0 & 0.0 \\ 0.0 & 1.0 & 0.0 \end{pmatrix} \begin{pmatrix} 1.0 & 0.0 & 0.0 \\ 0.0 & 1.0 & 0.0 \\ 0.0 & 0.0 & 1.0 \end{pmatrix} \begin{pmatrix} 1 \\ 1 \\ 1 \end{pmatrix} = \begin{pmatrix} 1 \\ 1 \end{pmatrix}$$

# FIG. 15

●CALCULATE UPDATE VALUE OF OD FLOW FROM ERROR OF LINK FLOW

$$\Delta q_1 = -2w_1 p^T \rho^T L^T (y' - y)) = -2 * 0.5 * \begin{pmatrix} 1.0 & 0.0 & 0.0 \\ 0.0 & 1.0 & 0.0 \\ 0.0 & 0.0 & 1.0 \end{pmatrix}^T \begin{pmatrix} 1.0 & 0.0 & 0.0 \\ 0.0 & 1.0 & 0.0 \\ 1.0 & 1.0 & 1.0 \end{pmatrix}^T \begin{pmatrix} 1.0 & 0.0 & 0.0 \\ 0.0 & 0.0 & 1.0 \end{pmatrix}^T \left( \begin{pmatrix} 2707 \\ 5979 \end{pmatrix} - \begin{pmatrix} 1 \\ 3 \end{pmatrix} \right)$$

$$= \begin{pmatrix} -8682 \\ -5976 \\ -5976 \end{pmatrix}$$

●CALCULATE UPDATE VALUE OF OD FLOW FROM ERROR OF BRANCH FLOW

$$\Delta q_2 = -2w_2 p^T \tau^T K^T (\eta' - \eta)) = -2 * 0.5 * \begin{pmatrix} 1.0 & 0.0 & 0.0 \\ 0.0 & 1.0 & 0.0 \\ 0.0 & 0.0 & 1.0 \end{pmatrix}^T \begin{pmatrix} 1.0 & 0.0 & 0.0 \\ 0.0 & 1.0 & 0.0 \end{pmatrix}^T \begin{pmatrix} 1.0 & 0.0 \\ 0.0 & 1.0 \end{pmatrix}^T \left( \begin{pmatrix} 2825 \\ 1513 \end{pmatrix} - \begin{pmatrix} 1 \\ 1 \end{pmatrix} \right) = \begin{pmatrix} -2824 \\ 1512 \\ 0 \end{pmatrix}$$

●CALCULATE UPDATE VALUE OF OD FLOW

$$\Delta q = \Delta q_1 + \Delta q_2 = \begin{pmatrix} -8682 \\ -5976 \\ -5976 \end{pmatrix} + \begin{pmatrix} -2824 \\ 1512 \\ 0 \end{pmatrix} = \begin{pmatrix} -11506 \\ -7488 \\ -5976 \end{pmatrix}$$

●UPDATE OD FLOW

$$q \leftarrow q - \gamma \Delta q = \begin{pmatrix} 1 \\ 1 \\ 1 \end{pmatrix} - 0.4 * \begin{pmatrix} -11506 \\ -7488 \\ -5976 \end{pmatrix} = \begin{pmatrix} 4603 \\ 2996 \\ 2391 \end{pmatrix}$$

FIG. 16

●ESTIMATION RESULT OF OD FLOW

| # | TIME SLOT | O-D | TRUE flow | INITIAL VALUE | ESTIMATION RESULT IN RELATED ART METHOD (ONLY LINK FLOW) | ESTIMATION RESULT IN PROPOSED |
|---|---|---|---|---|---|---|
| 1 | h1 (6:00-6:30) | node0-node3 | 2750 | 1 | 2775 | 2750 |
| 2 | | node1-node3 | 1500 | 1 | 1627 | 1490 |
| 3 | | node2-node3 | 1750 | 1 | 1627 | 1786 |

# FIG. 17

●ESTIMATION ERROR

Optimising link flow error only

PAIRS OF ESTIMATED VALUES AND TRUE VALUES ARE SUBSTANTIALLY AWAY FROM DIAGONAL LINE OF 45 DEGREES

estimated OD flow

3000
2750
2500
2250
2000
1750
1500
1250
1000

true OD flow

1000 1250 1500 1750 2000 2250 2500 2750 3000

RELATED ART METHOD

Optimising both link flow and turning flow error

PAIRS OF ESTIMATED VALUES AND TRUE VALUES ARE SUBSTANTIALLY ON DIAGONAL LINE OF 45 DEGREES

estimated OD flow

3000
2750
2500
2250
2000
1750
1500
1250
1000

true OD flow

1000 1250 1500 1750 2000 2250 2500 2750 3000

PRESENT EMBODIMENT

## OD FLOW ESTIMATION ERROR
### (RELATED ART METHOD VS PRESENT EMBODIMENT)

IT MAY BE SEEN THAT ALL OF FLOWS BETWEEN ODS HAVE BEEN IMPROVED

150

100

50

0

node0->node3          node1->node3          node2->node3

▨ RELATED ART METHOD          ◺ PRESENT EMBODIMENT

FIG. 18

| | r2 CURVE OF OD FLOW | OD FLOW ERROR RATE CURVE | LOSS CURVE |
|---|---|---|---|
| RELATED ART METHOD | ERROR OF OD FLOW IS SMALL IN PROPOSED METHOD AS COMPARED WITH RELATED ART METHOD | LOSS IS SUBSTANTIALLY 0, BUT ERROR OF OD FLOW IS LARGE | LOSS IS SUBSTANTIALLY 0, BUT ERROR OF OD FLOW IS LARGE |
| PRESENT EMBODIMENT | | LOSS IS SUBSTANTIALLY CLOSE TO 0, AND ERROR IN OD FLOW IS SMALL | LOSS IS SUBSTANTIALLY CLOSE TO 0, AND ERROR IN OD FLOW IS SMALL |

# FIG. 19

DIGITAL TWIN MANAGEMENT DEVICE ⌐10

PROCESSOR ⌐10d

MEMORY ⌐10c

COMMUNICATION INTERFACE ⌐10a

HDD ⌐10b

EP 4 542 433 A1

Europäisches
Patentamt

European
Patent Office

Office européen
des brevets

# EUROPEAN SEARCH REPORT

Application Number

EP 24 20 3499

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/058178 A1 (NIPPON TELEGRAPH & TELEPHONE [JP]) 13 April 2023 (2023-04-13) * abstract * * [0006], [0016], [0019], [0022]-[0024], [0029], [0036], [0038]; claims 3, 8; figure 1 * | 1-11 | INV. G06F30/20 |
| X | CN 116 863 704 A (CHINA HIGHWAY ENG CONSULTANTS CORP; ZHONGZI DATA CO LTD ET AL.) 10 October 2023 (2023-10-10) * abstract * * page 6 - page 6; claim 1 * | 1-11 | |
| X | AGUIAR ANA ET AL: "MobiWise: Eco-routing decision support leveraging the Internet of Things", SUSTAINABLE CITIES AND SOCIETY, ELSEVIER, AMSTERDAM, NL, vol. 87, 4 October 2022 (2022-10-04), XP087221970, ISSN: 2210-6707, DOI: 10.1016/J.SCS.2022.104180 [retrieved on 2022-10-04] * abstract * * pg. 2, col. 1, last paragraph (4 bullet points), col. 2, first paragraph (1 bullet point) section 7, section 7.1 section 9.2; figures 1-4 * | 1-11 | TECHNICAL FIELDS SEARCHED (IPC) G06F |

The present search report has been drawn up for all claims

| Place of search | Date of completion of the search | Examiner |
|---|---|---|
| Munich | 10 February 2025 | Brandiska, Pavlina |

EPO FORM 1503 03.82 (P04C01)

EP 4 542 433 A1

## ANNEX TO THE EUROPEAN SEARCH REPORT
## ON EUROPEAN PATENT APPLICATION NO.

EP 24 20 3499

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2025

| Patent document cited in search report | Publication date | Patent family member(s) | Publication date |
|---|---|---|---|
| WO 2023058178 A1 | 13-04-2023 | US 2024427959 A1<br>WO 2023058178 A1 | 26-12-2024<br>13-04-2023 |
| CN 116863704 A | 10-10-2023 | NONE | |

EPO FORM P0459

For more details about this annex : see Official Journal of the European Patent Office, No. 12/82

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005182383 A
- JP 2018101205 A
- JP 2013206406 A
- US 2022245462